# EUROPÄISCHE PATENTSCHRIFT

(11) **EP 0 344 518 B1**
(45) Veröffentlichungstag und Bekanntmachung des Hinweises auf die Patenterteilung: **19.07.1995**
(21) Anmeldenummer: 89108885.8
(22) Anmeldetag: 17.05.1989
(51) Int. Cl.: G01R 33/20

(54) **Pulssequenz für die Kernspin-Tomographie zur Erzeugung von Bildern mit unterschiedlichem T2-Kontrast**
Pulse sequences in nuclear spin tomography for producing images with differing T2 contrasts
Séquences d'impulsions en tomographie à spin nucléaire pour la production d'images avec différentes valeurs de contraste T2

(30) Priorität: 30.05.1988 DE 3818375
(43) Veröffentlichungstag der Anmeldung: 06.12.1989
(73) Patentinhaber: SIEMENS AKTIENGESELLSCHAFT, 80333 München (DE)
(72) Erfinder: Fischer, Hubertus, Dipl.-Phys., D-8520 Erlangen (DE); Ladebeck, Ralf, Dipl.-Phys., D-8520 Erlangen (DE); Schmitt, Franz, Dipl.-Phys., D-8523 Baiersdorf (DE)

(56) Entgegenhaltungen:
- EP-A- 0 191 431
- EP-A- 0 232 946
- EP-A- 0 255 220
- DE-A- 3 718 344
- GB-A- 2 126 731
- MAGNETIC RESONANCE IN MEDICINE, Band 3, Nr. 4, August 1986, Seiten 707-721, Duluth, MN, US; R. GRAUMANN et al.: "Multiple-spin-echo imaging with a 2D Fourier method"
- "Journal of Physics (E) Scientific Instruments" Bd. 21, 1988 Seiten 18 bis 30

## Beschreibung

Der Kontrast von in der Kernspin-Tomographie erzeugten Schnittbildern hängt von den Relaxationszeiten T1; T2 und der Dichte der untersuchten Substanz ab. Da die Relaxationszeit T2 unter anderem durch die chemische Verbindung der betrachteten Nuklide bestimmt ist, stellt sie ein aussagekräftiges Kriterium bei der Untersuchung von Objekten dar. Durch unterschiedlichen T₂-Kontrast, d.h. unterschiedlicher Helligkeit eines Bildpunktes je nach der entsprechenden T2-Zeit, können Bilder mit unterschiedlichem Aussagegehalt erzeugt werden.

Aus der Literaturstelle R. Graumann et al., "MAGNETIC RESONANCE IN MEDICINE" 3, 707-721 (1986), "Multiple spin echo imaging with a 2d Fourier method" ist eine Multi-Echo-Sequenz bekannt, bei der man verschieden stark T₂-gewichtete Bilder erhalten kann. Das Multi-Echo wird dabei durch ein Spin-Echo mit mindestens zwei Refokussierungsimpulsen erzielt.

Aus der Literaturstelle SMRM 1986, Book of Abstracts, S. 1462-1463, ist ein Verfahren zur Natrium-Bildgebung bekannt. Dabei tritt das Problem auf, daß Natrium sehr kurze T2-Komponenten aufweist. Um auch die kurzen T2-Komponenten zu erfassen, wird dabei nach einem 90°-Impuls zunächst direkt das FID-Signal ausgewertet, wobei die Ortsauflösung durch ein Rückprojektionsverfahren erfolgt. Anschließend wird nach einem durch einen 180°-HF-Impuls hervorgerufenen Spin-Echo nochmals ein Signal ausgelesen, mit dem die Signalanteile mit längeren T2-Zeiten erfaßt werden. Auch hierbei wird wieder das Rückprojektionsverfahren angewandt.

In der DE-A-3 718 344 sind sowohl eine Spin-Warp-Sequenz als auch eine FLASH-Sequenz beschrieben. Gegenstand der Anmeldung ist die Wiederholung von Meßsequenzen in Abhängigkeit vom Phasencodiergradienten. Die Anwendung eines Gradientenechos und eines Spinechos in einer einzigen Anregesequenz ist nicht vorgesehen.

In der EP-A-0 191 431 ist eine FLASH-Sequenz, also eine reine Gradientenecho-Sequenz, beschrieben. Die zusätzliche Erzeugung eines Spinechos ist nicht vorgesehen. In einer Ausführungsform wird die Richtung des zweiten Gradienten mehrfach umgekehrt und nach jeder Richtungsumkehr das entstehende Kernresonanzsignal ausgelesen.

Aus der GB-A-2 126 731 ist eine Pulssequenz bekannt, bei der nach einem 90°-Puls zunächst ein Gradientenecho als erstes Signal ausgelesen wird. Anschließend folgt ein 180°-Hochfrequenzpuls, nach dem ein Spinecho als zweites Signal ausgelesen wird. Schließlich folgt ein 90°-Hochfrequenzpuls, der die Magnetisierung in das thermische Gleichgewicht zurückbringt. Die beiden so gewonnenen Signale werden zur Verbesserung des Signal-Rausch-Verhältnisses, der Auflösung oder zur Bestimmung der Relaxationszeiten T1 und T2 und der Protonendichte M verwendet.

Aufgabe der Erfindung ist es, eine Pulssequenz so auszugestalten, daß nach einer einzigen Anregung Daten für Bilder mit unterschiedlichem T₂-Kontrast gewonnen werden, wobei die Meßzeit nicht verlängert werden soll.

Diese Aufgabe wird erfindungsgemäß durch die in Patentanspruch 1 angegebene Pulssequenz gelöst. Dabei ist es möglich, während der Messung eines Spin-Echo-Bildes gleichzeitig ein Gradienten-Echo-Bild zu messen, welches durch eine sehr kurze Echo-Zeit einen sehr geringen T₂-Kontrast hat. Gegenüber der getrennten Datenacquisition für Bilder unterschiedlichen T₂-Kontrastes wird damit eine Verkürzung der Meßzeit erreicht. Durch die gleichzeitige Messung sind die Bilder unabhängig von Patientenbewegungen zwischen den Messungen. Gegenüber der eingangs erwähnten Multi-Echo-Sequenz ist die Belastung durch Hochfrequenz-Erwärmung reduziert, da in jeder Pulssequenz nur ein 180°-Impuls notwendig ist.

Durch mehrfache Umkehr der Richtung des zweiten Gradienten gemäß Anspruch 2 können auch mehr als zwei Bilder mit unterschiedlichem T₂-Kontrast dargestellt werden.

Eine alternative Ausführungsform, die auf dem sogenannten Echoplanar-Verfahren basiert, ist in Patentanspruch 3 angegeben. Die Unteransprüche beinhalten vorteilhafte Ausführungsformen der Erfindung.

Ein Ausführungsbeispiel der Erfindung wird nachfolgend anhand der Figuren 1 bis 4 näher erläutert. Dabei zeigt:
FIG 1 den schematischen Aufbau eines Kernspin-Tomographiegerätes,
FIG 2 eine Pulssequenz als erstes Ausführungsbeispiel der Erfindung,
FIG 3 eine Pulssequenz als zweites Ausführungsbeispiel der Erfindung und
FIG 4 eine Pulssequenz als drittes Ausführungsbeispiel der Erfindung.

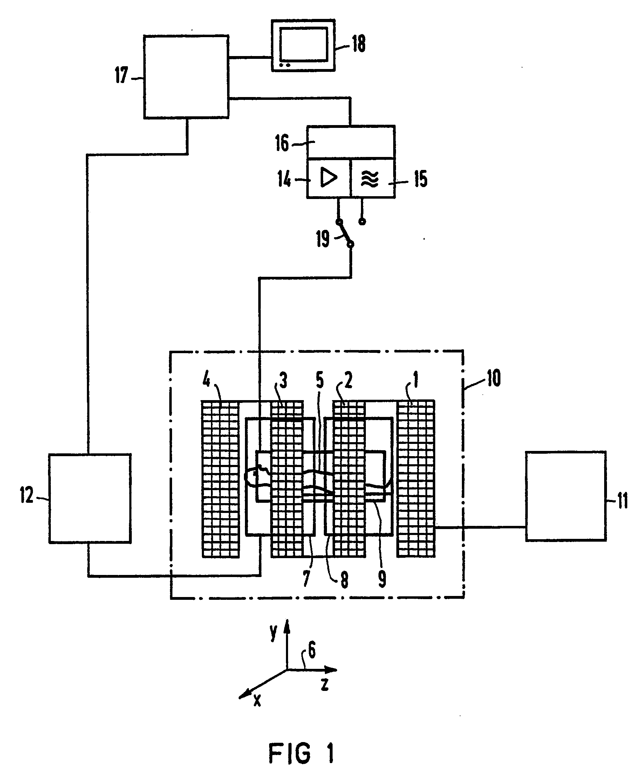

Die FIG 1 zeigt schematisch den prinzipiellen Aufbau eines Kernspin-Tomographiegerätes für die Erstellung von Bildern eines Untersuchungsobjektes. Die Spulen 1 bis 4 erzeugen ein magnetisches Grundfeld B₀, in welchem sich bei Anwendung zur medizinischen Diagnostik der zu untersuchende Körper 5 eines Patienten befindet. Diesem sind außerdem Gradientenspulen zugeordnet, die zur Erzeugung unabhängiger, zueinander senkrechter Magnetfeldgradienten der Richtungen x, y und z gemäß dem Koordinatenkreuz 6 vorgesehen sind. In der FIG sind der Übersichtlichkeit halber nur die Gradientenspulen 7 und 8 gezeichnet, die zusammen mit einem Paar gegenüberliegender, gleichartiger Gradientenspulen zur Erzeugung des x-Gradienten dienen. Die gleichartigen, nicht gezeichneten y-Gradientenspulen liegen parallel zum Körper 5 und oberhalb sowie unterhalb von ihm, die für das z-Gradientenfeld quer zu seiner Längsachse am Kopf- und am Fußende.

Die Anordnung enthält außerdem noch eine zur Erzeugung und Aufnahme der Kernresonanzsignale dienende Hochfrequenzspule 9. Die von einer strichpunktierten Linie 10 umgrenzten Spulen 1, 2, 3, 4, 7, 8 und 9 stellen das eigentliche Untersuchungsinstrument dar.

Es wird von einer elektrischen Anordnung aus betrieben, die ein Netzgerät 11 zum Betrieb der Spulen 1 bis 4 sowie eine Gradientenstromversorgung 12, an welcher die Gradientenspulen 7 und 8 sowie die weiteren Gradientenspulen liegen, umfaßt. Die Meßspule 9 ist über einen Signalverstärker 14 bzw, einen Hochfrequenzsender 15 an einen Prozeßrechner 17 gekoppelt, an dem zur Ausgabe der Abbildung ein Bildschirmgerät 18 angeschlossen ist. Die Komponenten 14 und 15 bilden eine Hochfrequenzeinrichtung 16 zur Signalerzeugung und -aufnahme. Ein Umschalter 19 ermöglicht das Umschalten von Sende- auf Empfangsbetrieb.

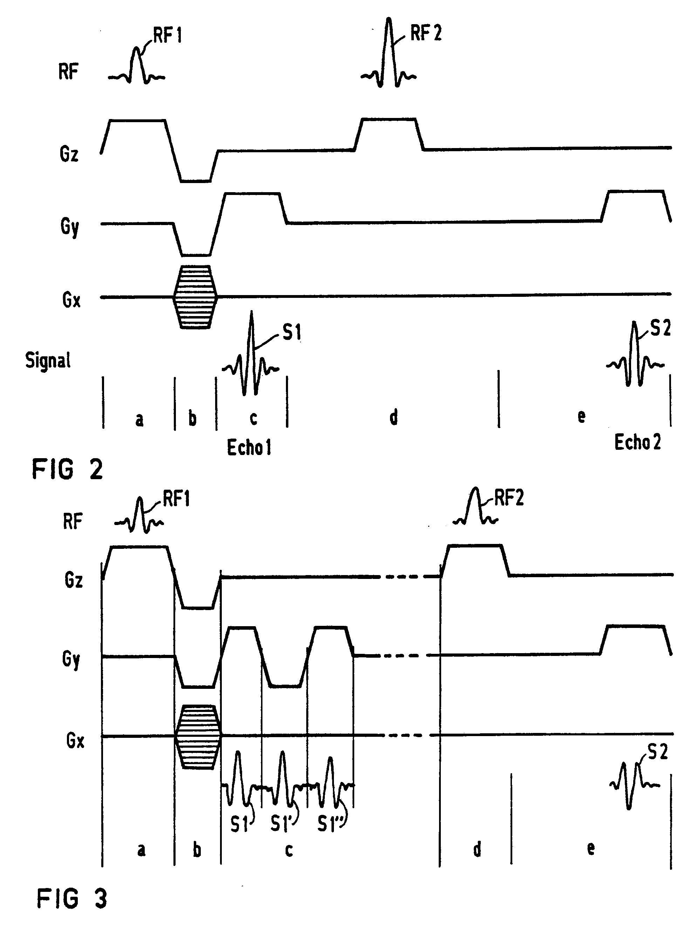

FIG 2 zeigt als erstes Ausführungsbeispiel der Erfindung eine Pulssequenz zur Ansteuerung des Kernspin-Tomographen. In einem ersten Schritt wird an das Untersuchungsobjekt zunächst ein Hochfrequenz-lmpuls RF1 zusammen mit einem Gradienten G_{z} angelegt. Durch entsprechende Wahl des Frequenzspektrums des Hochfrequenz-Impulses RF1 werden damit selektiv nur Kerne in einer bestimmten Schicht des Untersuchungsobjektes angeregt. Das später auszulesende Signal weist seine maximale Amplitude auf, wenn der Hochfrequenz-Impuls RF1 so bemessen ist, daß ein Flip-Winkel von 90° entsteht. Es sind aber auch kleinere Flip-Winkel möglich.

In einem zweiten Schritt b) wird der Gradient G_{z} umgekehrt, um die in Schritt a) durch den Gradienten G_{z} verursachte Dephasierung der Spins in z-Richtung rückgängig zu machen. Außerdem wird ein negativer Gradient G_{y} angelegt, der eine Dephasierung der Spins in y-Richtung verursacht. Schließlich wird ein Gradient Gₓ angelegt, der als Phasencodiergradient für die x-Richtung dient. Die gesamte Sequenz wird - wie nachfolgend noch näher erläutert - mehrfach durchgeführt, wobei bei jeder Sequenz die Amplitude des Gradienten Gₓ wechselt.

In einem dritten Schritt c) wird schließlich die Richtung des Gradienten G_{y} umgekehrt, so daß die vorherige Dephasierung in y-Richtung aufgehoben wird und als Signal S1 ein sogenanntes Gradienten-Echo empfangen wird. Die Amplitude des Signals S1 bei vollständiger Rephasierung entspricht dem FID-Signal, so daß man auch sagen kann, daß dieses Signal unter der Einhüllenden des FID-Signals ausgelesen wird. Dieses erste Signal S1 weist einen relativ geringen T₂-Kontrast auf, da es nahe am Anregeimpuls ausgelesen wird.

In einem vierten Schritt d) wird ein weiterer Hochfrequenz-lmpuls RF2 unter der Wirkung eines Gradienten G_{z} eingestrahlt. Der Hochfrequenz-Impuls und der Gradient G_{z} sind dabei im Ausführungsbeispiel so bemessen, daß selektiv wieder dieselbe Schicht angesprochen wird wie bei Schritt a). Alternativ könnte man den HF-lmpuls RF2 auch nicht ortsselektiv. d.h. ohne Gradienten G_{z} und sehr schmalbandig ausführen. Damit könnte man z.B. selektiv das Signal von Fett oder Wasser refokussieren. Der Hochfrequenz-lmpuls RF2 ist so dimensioniert, daß er bevorzugt einem Flip-Winkel von 180° entspricht. Damit wird die Amplitude des nachfolgenden Auslesesignals maximal. Es sind aber auch Abweichungen vom Flip-Winkel von 180° möglich. Mit dem Hochfrequenz-Impuls RF2 mit einem Flip-Winkel von näherungsweise 180° wird durch Rephasierung ein in der Kernspin-Tomographie allgemein gebräuchliches Spin-Echo hervorgerufen. Dieses wird im darauffolgenden Schritt e) unter der Wirkung eines eingeschalteten, als Auslesegradient wirkenden Gradienten G_{y} als Signal S2 ausgelesen. Da dies nunmehr unter dem Spin-Echo geschieht, kann man auch davon sprechen, daß das Signal S2 unter der Einhüllenden des Spin-Echos ausgelesen wird.

Das Signal S2 ist nun wesentlich stärker T₂-gewichtet, da der Abstand zum Anregeimpuls RF1 wesentlich größer ist. Der Helligkeitsunterschied, d.h also der Kontrast zwischen Bildpunkten mit unterschiedlicher T2-Zeit wird damit vergrößert.

Bei dieser Sequenz wird also durch den Hochfrequenz-lmpuls RF2 die bereits für die Bildgebung vorbereitete Magnetisierung refokussiert und ein zweites Echo in Form des Signals S2 gemessen. Durch diese Sequenz ist es möglich, in der Meßzeit für ein Spin-Echo-Bild gleichzeitig noch ein Gradienten-Echo-Bild mit wesentlich geringerem T₂-Kontrast zu messen. Im Gegensatz zum eingangs beschriebenen bekannten Mehrfach-Echo-Verfahren wird kein zweiter 180° - Hochfrequenz-lmpuls verwendet und somit die damit verbundene Hochfrequenz-Erwärmung des Patienten und die Probleme mit stimulierten Echos vermieden.

Aus einem Satz von Signalen S1 und einem Satz von Signalen S2 kann nun jeweils unabhängig voneinander ein vollständiges Schnittbild des Untersuchungsobjektes gewonnen werden. Dazu werden die Signale S1, S2 abgetastet und jeweils in eine Zeile einer Matrix abgelegt. Für jede Sequenz wird bei fortgeschaltetem Phasencodiergradienten Gₓ eine neue Zeile gebildet. Aus den beiden so entstandenen Matrizen kann durch zweidimensionale Fourier-Transformation ein Bild gewonnen werden. Ein entsprechendes Verfahren ist beispielsweise in der US-PS 4 070 611 beschrieben. Das auf den Signalen S1 basierende Bild weist einen wesentlich kleineren T₂-Kontrast als das auf den Signalen S2 basierende Bild auf. Somit bekommt man zwei Bilder mit unterschiedlichem diagnostischem Aussagegehalt, ohne die Untersuchungszeit zu verlängern.

In FIG 3 ist ein weiteres ausführungsbeispiel der Erfindung dargestellt. Der Unterschied zum Ausführungsbeispiel nach FIG 2 besteht dann daß im Schritt c) die Richtung des Gradienten G_{y} mehrfach umgekehrt wird. Mit jeder Gradientenumkehr wird ein Spin-Echo-Signal S1, S1′, S1′ erzeugt. Jedes dieser Signale kann wiederum zur Erzeugung eines eigenen Bildes benutzt werden, so daß man mehrere Bilder mit unterschiedlichem T₂-Kontrast erhalten kann.

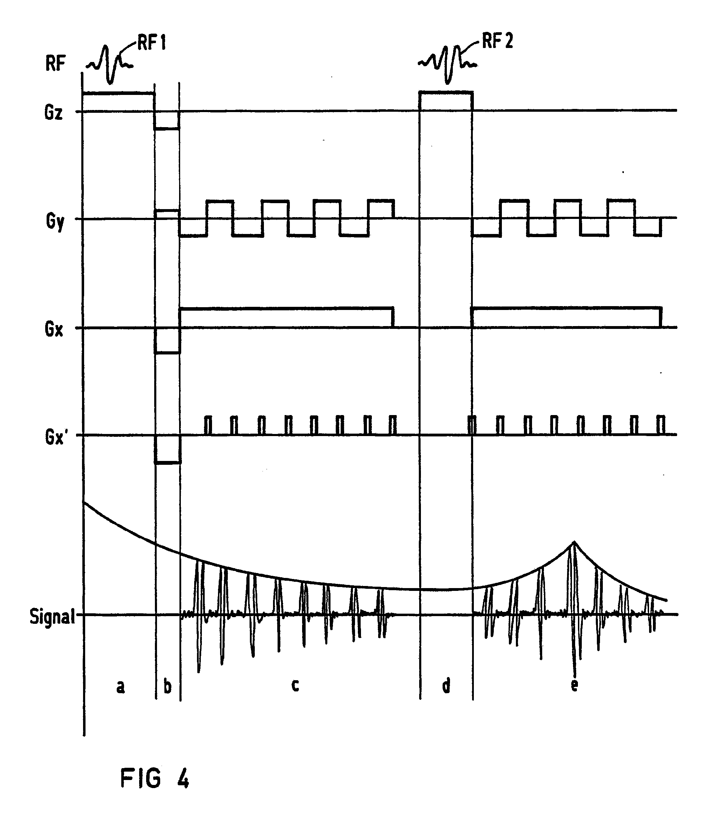

Bei einem weiteren Ausführungsbeispiel nach FIG 4 wird zunächst ebenfalls ein Hochfrequenzimpuls RF1, bevorzugt ein 90°-Impuls eingestrahlt. Durch die gleichzeitige Einwirkung eines Gradienten G_{z} wird dieser Hochfrequenz-lmpuls RF1 schichtselektiv.

In dem darauffolgenden Schritt b) wird der Gradient G_{z} umgekehrt, um die in Schritt a) stattfindende Dephasierung der Spins in z-Richtung rückgängig zu machen. Außerdem wird ein negativer Gradient Gₓ bzw. Gₓ′ zur Vorphasierung in x-Richtung eingeschaltet.

In einem darauffolgenden Schritt c) wird ein Gradient G_{y} angelegt, der mehrfach invertiert wird. Dabei wird den Spins in x-Richtung nach jeder Inversion eine andere Phase aufgeprägt, so daß nach einer ausreichenden Zahl von Inversionen nach einem einzigen Hochfrequenz-Impuls RF1 die vollständige Information für ein Bild erhalten wird. Die Aufprägung der Phaseninformation kann auf zwei Arten geschehen. Die eine Möglichkeit ist, einen schwachen Phasencodiergradienten gₓ während der ganzen Auslesezeit eingeschaltet zu lassen. Da das Amplituden-Zeitintegral des Phasencodiergradienten für die Phase maßgeblich ist, nimmt die Phasendrehung mit der Anzahl der Gradienten-Echos zu. Eine weitere Möglichkeit besteht darin, bei jeder Gradientenumkehr einen kleinen Phasencodierimpuls einzuschalten, der in FIG 4 mit Gₓ′ bezeichnet ist.

Diese Art der Bildgewinnung wird als Echo-Planar-Verfahren bezeichnet und ist näher in der US-PS 4 451 788 beschrieben.

Nachdem im Schritt c) die Signale für ein erstes Bild gewonnen wurden, wird in einem Schritt d) ein zweiter HF-Impuls RF2, der vorzugsweise einen Flip-Winkel von 180° erzeugt, eingestrahlt. Gleichzeitig wird wieder ein Gradient G_{z} eingeschaltet, so daß auch der Hochfrequenz-lmpuls RF2 frequenzselektiv ist. Auf diesen Hochfrequenz-Impuls RF2 folgt in einem Schritt e) ein Spin-Echo, so daß die nachfolgenden Signale S2 unter der Einhüllenden des Spin-Echos ausgelesen werden. Auch hier wird wieder ein Gradient G_{y} mit wechselnder Polarität eingeschaltet, so daß wieder eine Reihe von Echosignalen entsteht.

Auch hierbei kann entweder ein kontinuierlicher Phasencodiergradient Gₓ oder ein Phasencodiergradient Gₓ′ mit einzelnen Impulsen bei Polaritätswechsel des Gradienten G_{y} eingesetzt werden. Auch im Schritt e) erhält man damit die vollständige Information zur Erzeugung eines Schnittbildes. Die Bildrekonstruktion kann wiederum durch Eintragen der abgetasteten Signalwerte in eine Matrix und eine anschließende zweidimensionale Fourier-Transformation erfolgen. Die aus den Signalen im Schritt c) und aus den Signalen im Schritt e) gewonnenen Bilder unterscheiden sich wiederum durch unterschiedlichen T2-Kontrast und weisen somit unterschiedlichen diagnostischen Aussagegehalt auf. Außerdem hat jedes der Bilder spezifische Vor-und Nachteile. Die aufgrund der Signale in Schritt c) unter der Einhüllenden des FID-Signals gewonnenen Bilder weisen höhere Amplituden auf, sind jedoch anfälliger gegen Inhomogenitäten des Grundfeldes. Die im Schritt e) unter der Einhüllenden des Spin-Echos gewonnenen Signale sind unempfindlicher gegen Grundmagnetfeld-lnhomogenitäten, zeigen aber stärker T₂-gewichtete Bilder. Dadurch, daß mit dem erfindungsgemäßen Verfahren zwei unterschiedliche Bilder gewonnen werden, können die Vorteile des jeweiligen Bildes genutzt werden.

## Patentansprüche

1. Erzeugungs verfahren von Kernspintomographie-Bildern eines Untersuchungsobjekts mit unterschiedlichem T₂-Kontrast, bei dem zur Signalgewinnung n mal folgende Schritte hintereinander in einem vorgegebenen Abstand (TR) durchgeführt werden:
a) Anlegen eines ersten selektiven HF-Impulses (RF1) zusammen mit einem Gradienten (G_{z}) in z-Richtung als Schichtselektionsgradient,
b) Umkehren des Schichtselektionsgradienten (G_{z}) zur Rephasierung der Spins in z-Richtung, Anlegen eines zweiten Gradienten (G_{y}) in y-Richtung zur Dephasierung der Spins in y-Richtung und Anlegen eines dritten Gradienten (Gₓ) in x-Richtung mit einem von Schritt zu Schritt variierenden Amplituden-Zeitintegral zur Phasencodierung der Spins in x-Richtung,
c) Anlegen des zweiten Gradienten (G_{y}) in y-Richtung umgekehrt zur Richtung nach Schritt b) und Auslesen des entstehenden HF-Signals (S1) nach einer kurzen Echozeit mit einem daraus resultierenden geringen T2-Kontrast,
d) Anlegen eines zweiten HF-Impulses (RF2) mit einem zugeordneten Flip-Winkel von näherungsweise 180°,
e) Anlegen des zweiten Gradienten (G_{y}) in y-Richtung und Auslesen des entstehenden HF-Signals (S2),
wobei die drei Richtungen x, y und z aufeinander senkrecht stehen.

2. Verfahren nach Anspruch 1, wobei in Schritt c) die Richtung des zweiten Gradienten (G_{y}) mehrfach umgekehrt und nach jeder Richtungsumkehr das entstehende HF-Signal (S1, S1′, S1˝) ausgelesen wird.

3. Erzeugungsverfahren von Kernspintomographiebildern mit unterschiedlichem T₂-Kontrast, wobei die Signalgewinnung in folgenden aufeinanderfolgenden Schritten durchgeführt wird:
a) Anlegen eines ersten selektiven HF-Impulses (RF1) zusammen mit einem Gradienten (G_{z}) in z-Richtung als Schichtselektionsgradient,
b) Umkehren des Gradienten (G_{z}) zur Rephasierung der Spins in z-Richtung und Anlegen eines dritten Gradienten (Gₓ, Gₓ′) zur Vorphasierung der Spins in x-Richtung,
c) Anlegen eines zweiten Gradienten (G_{y}) in y-Richtung, mehrfach Richtungsumkehr des zweiten Gradienten (G_{y}) und Auslesen des nach jeder Richtungsumkehr jeweils entstehenden HF-Signals (S1) nach einer kurzen Echozeit mit einem daraus resultierenden T₂-Kontrast, wobei zusätzlich ein dritter Gradient (Gₓ, Gₓ′) angelegt wird, dessen Amplituden-Zeitintegral von Richtungswechsel zu Richtungswechsel des zweiten Gradienten (G_{y}) zunimmt,
d) Anlegen eines zweiten HF-Impulses (RF2) mit einem zugeordneten Flip-Winkel von näherungsweise 180°,
e) Anlegen des zweiten Gradienten (G_{y}) in y-Richtung und Auslesen des entstehenden HF-Signals.

4. Verfahren nach Anspruch 3, wobei in Schritt e) die Richtung des y-Gradienten mehrfach umgekehrt wird und wobei zusätzlich ein dritter Gradient (Gₓ, Gₓ′) angelegt wird, dessen Amplituden-Zeitintegral von Richtungswechsel zu Richtungswechsel des zweiten Gradienten (G_{y}) zunimmt.

5. Verfahren nach Anspruch 3, wobei der dritte Gradient (Gₓ) während des Schrittes c) kontinuierlich eingeschaltet ist.

6. Verfahren nach Anspruch 4, wobei der dritte Gradient (Gₓ) während des Schrittes e) kontinuierlich eingeschaltert ist.

7. Verfahren nach Anspruch 3, wobei der dritte Gradient (Gₓ) während des Schrittes c) bei jedem Richtungswechsel als im Vergleich zu den Impulslängen des zweiten Gradienten (G_{y}) kurzer Impuls eingeschaltet wird.

8. Verfahren nach Anspruch 4, wobei der dritte Gradient (Gₓ) während des Schrittes e) bei jedem Richtungswechsel als im Vergleich zu den Impulslängen des zweiten Gradienten (G_{y}) kurzer Impuls eingeschaltet wird.

9. Verfahren nach einem der Ansprüche 1 bis 8, wobei der zweite HF-Impuls (RF2) sehr schmalbandig ist.

10. Verfahren nach einem der Ansprüche 1 bis 8, wobei der zweite HF-Impuls (RF2) zusammen mit einem ersten Gradienten (G_{z}) in z-Richtung als Schichtselektionsgradient angelegt wird und daß die Bandbreite des zweiten HF-Impulses (RF2) nach der gewählten Schichtdicke bemessen wird.

## Claims

1. Method of production of nuclear spin tomography images of an examination subject having differing T₂-contrast, wherein for the purpose of obtaining signals n times the following steps are carried out in succession within a given interval (TR):
a) application of a first selective RF-pulse (RF1) together with a gradient (G_{z}) in the z-direction as a layer selection gradient,
b) reversal of the layer selection gradient (G_{z}) for the purpose of re-phasing the spins in the z-direction, application of a second gradient (G_{y}) in the y-direction for the purpose of dephasing the spins in the y-direction and application of a third gradient (Gₓ) in the x-direction with an amplitude-time integral, which varies from step to step, for the purpose of phase-coding the spins in the x-direction,
c) application of the second gradient (G_{y}) in the y-direction in the reverse direction to the direction according to step b) and read-out of the resultant RF-signal (S1) according to a short echo time with a small T₂-contrast resulting therefrom,
d) application of a second RF-pulse (RF2) with an associated flip-angle of approximately 180°,
e) application of the second gradient (G_{y}) in the y-direction and read-out of the resultant RF-signal (S2),
wherein the three directions x, y and z are perpendicular to each other.

2. Method according to claim 1, wherein in step c) the direction of the second gradient (G_{y}) is reversed repeatedly and after each reversal of direction the resultant RF-signal (S1, S1′, S1˝) is read out.

3. Method of production of nuclear spin tomography images having differing T₂-contrast, wherein the signal obtainment is effected in the following successive steps:
a) application of a first selective RF-pulse (RF1) together with a gradient (G_{z}) in the z-direction as a layer selection gradient,
b) reversal of the gradient (G_{z}) for the purpose of re-phasing the spins in the z-direction and application of a third gradient (Gₓ, Gₓ′) for the purpose of pre-phasing the spins in the x-direction;
c) application of a second gradient (G_{y}) in the y-direction, repeated reversal of direction of the second gradient (G_{y}) and read-out of the respective RF-signal (S1), which results after each reversal of direction, according to a short echo time with a T₂-contrast resulting therefrom, with in addition a third gradient (Gₓ, Gₓ′) being applied, the amplitude-time integral of which third gradient increases from change in direction to change in direction of the second gradient (G_{y}),
d) application of a second RF-pulse (RF2) with an associated flip-angle of approximately 180°,
e) application of the second gradient (G_{y}) in the y-direction and read-out of the resultant RF-signal.

4. Method according to claim 3, wherein in step e) the direction of the y-gradient is reversed repeatedly and wherein in addition a third gradient (Gₓ, Gₓ′) is applied, the amplitude-time integral of which third gradient increases from change in direction to change in direction of the second gradient (G_{y}).

5. Method according to claim 3, wherein the third gradient (Gₓ) is established continuously during step c).

6. Method according to claim 4, wherein the third gradient (Gₓ) is established continuously during step e).

7. Method according to claim 3, wherein the third gradient (Gₓ) is established during step c) in the case of each change in direction, as, in comparison with the pulse lengths of the second gradient (G_{y}), a short pulse.

8. Method according to claim 4, wherein the third gradient (Gₓ) is established during step e) in the case of each change in direction, as, in comparison with the pulse lengths of the second gradient (G_{y}), a short pulse.

9. Method according to one of the claims 1 to 8, wherein the second RF-pulse (RF2) has a very narrow band.

10. Method according to one of the claims 1 to 8, wherein the second RF-pulse (RF2) is applied together with a first gradient (G_{z}) in the z-direction as a layer selection gradient and in that the band width of the second RF-pulse (RF2) is dimensioned according to the selected layer thickness.

## Revendications

1. Procédé de production d'images de tomographie à spin nucléaire d'un objet d'examen ayant des contrastes T₂ différents, selon lequel pour l'obtention du signal, on exécute successivement n fois les étapes indiquées ci-après, à une distance (TR) prédéterminée :
a) application d'une première impulsion HF sélective (RF1) ainsi que d'un gradient (G_{z}) dans la direction z en tant que gradient de sélection de couche,
b) inversion du gradient de sélection de couche (G_{z}) pour la remise en phase des spins dans la direction z, application d'un second gradient (G_{y}) dans le sens y pour déphaser les spins dans la direction y et application d'un troisième gradient (Gₓ) dans la direction x ayant une intégrale de l'amplitude dans le temps, qui varie d'une étape à l'autre, pour le codage de phase des spins dans la direction x,
c) application du second gradient (G_{y}) dans le sens y, inverse du sens choisi lors de l'étape b) et lecture du signal HF apparaissant (S1) après un bref temps d'écho, avec un faible contraste T2 en résultant;
d) application d'une seconde impulsion HF (RF2) ayant un angle de flip associé égal approximativement à 180°,
e) application du second gradient (G_{y}) dans la direction y et lecture du signal HF apparaissant (S2),
les trois directions x, y et z étant perpendiculaires entre elles.

2. Procédé suivant la revendication 1, selon lequel, lors de l'étape c), on inverse plusieurs fois le sens du second gradient (G_{y}) et, après chaque inversion de sens, on lit le signal HF apparaissant (S1,S1′,S1˝).

3. Procédé de production d'images de tomographie à spin nucléaire ayant des contrastes (T₂) différents, selon lequel l'obtention des signaux s'effectue selon des étapes successives indiquées ci-après :
a) application d'une première impulsion HF sélective (RF1) ainsi que d'un gradient (G_{z}) dans la direction z en tant que gradient de sélection de couche,
b) inversion du gradient (G_{z}) pour la remise en phase des spins dans la direction z, et application d'un troisième gradient (Gₓ,Gₓ′) pour avancer la phase des spins dans la direction x,
c) application du second gradient (G_{y}) dans la direction y, inversion multiple du sens du second gradient (G_{y}) et lecture du signal HF (S1) apparaissant après chaque inversion de sens, au bout d'un bref temps d'écho avec un contraste (T₂) résultant, un troisième gradient (Gₓ,Gₓ′) étant en outre appliqué, gradient dont l'intégrale de l'amplitude dans le temps augmente, d'un changement de sens du second gradient (G_{y}) au suivant,
d) application d'une seconde impulsion HF (RF2) ayant un angle de flip associé égal approximativement à 180°,
e) application du second gradient (G_{y}) dans la direction y et lecture du signal HF apparaissant (S2).

4. Procédé suivant la revendication 3, selon lequel lors de l'étape e), on inverse le sens du gradient y à plusieurs reprises et en outre on applique un troisième gradient (Gₓ, Gₓ′), dont l'intégrale de l'amplitude dans le temps augmente d'un changement de sens du second gradient (G_{y}) au suivant.

5. Procédé suivant la revendication 3, selon lequel on applique le troisième gradient (Gₓ) continûment pendant l'étape c).

6. Procédé suivant la revendication 4, selon lequel on applique le troisième gradient (Gₓ) continûment pendant l'étape e).

7. Procédé suivant la revendication 3, selon lequel on applique le troisième gradient (Gₓ) pendant l'étape c) lors de chaque changement de sens, sous la forme d'une impulsion brève par rapport aux longueurs d'impulsions du second gradient (G_{y}).

8. Procédé suivant la revendication 4, selon lequel le troisième gradient (Gₓ) est appliqué, pendant l'étape e), lors de chaque changement de direction, sous la forme d'une impulsion brève par rapport aux longueurs d'impulsions du second gradient (G_{y}).

9. Procédé suivant l'une des revendications 1 à 8, selon lequel la seconde impulsion HF (RF2) est à bande très étroite.

10. Procédé suivant l'une des revendications 1 à 8, selon lequel on applique la seconde impulsion HF (RF2) conjointement avec un premier gradient (G_{z}) dans la direction z, en tant que gradient de sélection de couche, et on dimensionne la largeur de bande de la seconde impulsion HF (RF2) en fonction de l'épaisseur de couche choisie.
